# EUROPÄISCHE PATENTANMELDUNG

(11) **EP 3 034 525 A1**
(43) Veröffentlichungstag der Anmeldung: **22.06.2016**
(21) Anmeldenummer: 14199295.8
(22) Anmeldetag: 19.12.2014
(51) Int. Cl.: C08F 226/06, C08F 255/02, C09D 123/04, H01L 31/00, C09D 4/06

(54) **Covernetzersysteme für Verkapselungsfolien umfassend Pentaerythritolverbindungen**

(71) Anmelder: Evonik Degussa GmbH, 45128 Essen (DE)
(72) Erfinder: Ulbricht, Daniel, 64295 Darmstadt (DE); Hein, Marcel, 63843 Niedernberg (DE); Kleff, Frank, 63486 Brüchköbel-Oberissigheim (DE); Schauhoff, Stephanie, 63225 Langen (DE); Ohlemacher, Jürgen, 61118 Bad Vilbel (DE)

(57) **Zusammenfassung**

Die vorliegende Erfindung betrifft eine erste Zusammensetzung **(A)** umfassend (i) mindestens eine Verbindung **(I)** ausgewählt aus der Gruppe bestehend aus Triallylisocyanurat, Triallylcyanurat, wobei die Verbindung **(I)** bevorzugt Triallylisocyanurat ist; und (ii) mindestens eine Pentaerythritolverbindung. Daneben betrifft die vorliegende Erfindung auch eine zweite Zusammensetzung **(B)** umfassend die erste Zusammensetzung **(A)** und mindestens ein Polyolefincopolymer. Schließlich betrifft die vorliegende Erfindung die Verwendung der Zusammensetzung **(B)** zur Herstellung einer Folie zur Verkapselung einer elektronischen Vorrichtung, insbesondere einer Solarzelle.

## Beschreibung

Die vorliegende Erfindung betrifft eine erste Zusammensetzung **(A)** umfassend (i) mindestens eine Verbindung **(I)** ausgewählt aus der Gruppe bestehend aus Triallylisocyanurat, Triallylcyanurat, wobei die Verbindung **(I)** bevorzugt Triallylisocyanurat ist; und (ii) mindestens eine Pentaeryhtritolverbindung. Daneben betrifft die vorliegende Erfindung auch eine zweite Zusammensetzung **(B)** umfassend die erste Zusammensetzung **(A)** und mindestens ein Polyolefincopolymer. Schließlich betrifft die vorliegende Erfindung die Verwendung der Zusammensetzung **(B)** zur Herstellung einer Folie zur Verkapselung einer elektronischen Vorrichtung, insbesondere einer Solarzelle.

### Hintergrund der Erfindung

Photovoltaikmodule (Photovoltaik = "PV") bestehen üblicherweise aus einer Lage symmetrisch angeordneter Siliziumzellen, welche in zwei Lagen einer Schutzfolie eingeschweißt werden. Diese Schutzfolie ist selbst wiederum durch ein *"backsheet"* auf ihrer Rück- und ein *"frontsheet"* auf ihrer Vorderseite stabilisiert. *"Backsheet"* und *"frontsheet"* können sowohl geeignete Kunststofffolien sein als auch aus Glas bestehen. Die Funktion des Verkapselungsmaterials besteht im Wesentlichen darin, das PV-Modul vor Witterungseinflüssen und mechanischer Belastung zu schützen, weshalb die mechanische Stabilität des jeweiligen Verkapselungsmaterials eine wichtige Eigenschaft darstellt. Daneben weisen gute Verkapselungsmaterialien eine schnelle Aushärtungsgeschwindigkeit, einen hohen Gelgehalt, eine hohe Transmission, eine geringe Neigung zu temperatur- und wärmeinduzierter Verfärbung sowie eine hohe Adhäsion (also eine geringe Neigung zur UV-induzierten Delaminierung) auf.

Die im Stand der Technik (zum Beispiel WO 2008/036708 A2) zu diesem Zweck beschriebenen Verkapselungsmaterialien beruhen typischerweise auf Materialien wie Silikonharzen, Polyvinylbutyralharzen, Ionomeren, Polyolefinfolien oder Ethylen-Vinylacetat-Copolymeren ("EVA").

Verfahren zur Herstellung solcher Verkapselungsfolien sind dem Fachmann geläufig (EP 1 164 167 A1). In diesen Verfahren werden die Vernetzer zusammen mit einem Polyolefincopolymer (und eventuell weiteren Additiven) zum Beispiel in einem Extruder homogen vermischt und dann zu einer Folie extrudiert. Das in der EP 1 164 167 A1 beschriebene Verfahren betrifft EVA, ist aber auch auf Folien aus anderen, zum Beispiel den vorgenannten, Materialien anwendbar.

Die Verkapselung der Siliziumzellen erfolgt typischerweise in einem Vakuumlaminierofen (EP 2 457 728 A1). Dazu wird der Schichtaufbau des PV-Moduls vorbereitet und in einem Laminierofen (bestehend aus zwei durch eine Membran getrennten Kammern) zunächst langsam aufgeheizt. Dadurch erweicht das Polyolefincopolymer (zum Beispiel EVA). Gleichzeitig wird der Ofen evakuiert, um die Luft zwischen den Schichten zu entfernen. Dieser Schritt ist der kritischste und dauert zwischen 4 bis 6 Minuten. Im Anschluss daran wird das Vakuum über die zweite Kammer gebrochen, und über Anlegen eines Drucks werden die Schichten des Moduls miteinander verschweißt. Gleichzeitig wird bis zur Vernetzungstemperatur weiter aufgeheizt, wobei in diesem letzten Schritt dann die Vernetzung der Folie stattfindet.

Gerade EVA wird standardmäßig bei der Herstellung von Verkapselungsfolien für Solarmodule eingesetzt. Allerdings weist es auch einen geringeren spezifischen elektrischen Durchgangswiderstand p als zum Beispiel Polyolefinfolien auf. Dies macht den Einsatz von EVA-Folien als Verkapselungsmaterial unattraktiver, da gerade Verkapselungsmaterialien mit hohem spezifischem elektrischem Durchgangswiderstand p gewünscht sind.

Bei PV-Modulen stellt nämlich der sogenannte "PID"-Effekt (PID = *"potential induced degradation")* derzeit ein großes Qualitätsproblem dar. Unter dem Begriff PID versteht man eine spannungsbedingte Leistungsdegradation, hervorgerufen durch sogenannte "Leckströme" innerhalb des PV-Moduls.

Ursache für die schädlichen Leckströme ist neben dem Aufbau der Solarzelle die Spannungslage der einzelnen PV-Module gegenüber dem Erdpotential - bei den meisten ungeerdeten PV-Systemen sind die PV-Module einer positiven oder negativen Spannung ausgesetzt. PID tritt meistens bei einer negativen Spannung gegenüber Erdpotential auf und wird durch hohe Systemspannungen, hohe Temperaturen und hohe Luftfeuchtigkeit beschleunigt. In der Folge wandern Natriumionen aus dem Deckglas des PV-Moduls an die Grenzfläche der Solarzelle und verursachen dort Schäden *("shunt"),* die zu Leistungsverlusten und sogar zum Totalverlust des PV-Moduls führen können.

Das Risiko des Eintretens eines PID-Effektes kann durch die Erhöhung des spezifischen elektrischen Durchgangswiderstands p der Verkapselungsfolien deutlich reduziert werden.

Der spezifische elektrische Durchgangswiderstand p oder auch Resistivität ("*volume resistivity",* im Folgenden auch abgekürzt als "VR") ist eine temperaturabhängige Materialkonstante. Er wird zur Berechnung des elektrischen Widerstands eines homogenen elektrischen Leiters genutzt. Der spezifische elektrische Durchgangswiderstand wird erfindungsgemäß mittels ASTM-D257 bestimmt.

Je höher der spezifische elektrische Durchgangswiderstand p eines Materials ist, desto geringer ist die Anfälligkeit von Photovoltaikmodulen gegenüber dem PID-Effekt. Eine wesentliche, positive Auswirkung bei der Steigerung des spezifischen elektrischen Durchgangswiderstands p von Verkapselungsfolien ist daher die Erhöhung der Lebensdauer und Effizienz von PV-Modulen.

Im Stand der Technik wird das Problem des PID-Effekts im Zusammenhang mit Verkapselungsfolien für PV-Module in der CN 103525321 A diskutiert. Diese Schrift beschreibt eine EVA-basierte Folie zur Verkapselung von Solarzellen, welche als Covernetzer Triallylisocyanurat ("TAIC") und Trimethylolpropantrimethacrylat ("TMPTMA") sowie als weitere Additive bevorzugt ein Polyolefinionomer und ein Polysiloxan zur Hydrophobisierung enthält. Diese Folie weist einen verminderten PID-Effekt auf. Nachteilig an ihr ist allerdings, dass Polyolefinionomere relativ teuer sind. Außerdem wirken sich Polysiloxane negativ auf die Haftungseigenschaften aus. Zudem werden in den Beispielen keine spezifischen Angaben darüber gemacht, mit welchen Konzentrationen welche Verbesserungen erreicht werden können.

Eine Vernetzerkombination aus TAIC und TMPTMA beschreibt auch die JP 2007-281135 A. Das TMPTMA bewirkt hierbei eine Beschleunigung der Vernetzungsreaktion und führt damit zu einer erhöhten Produktivität.

Die JP 2012-067174 A und die JP 2012-087260 A beschreiben eine auf EVA bzw. einem Polyolefin basierende Verkapselungsfolie für Solarzellen, die neben TAIC zum Beispiel Ethylenglykoldimethacrylat, Neopentylglykoldimethacrylat, 1,6-Hexandioldimethacrylat als Vernetzer aufweist. Diese Co-Crosslinker verlangsamen die Vernetzungsreaktion am Anfang etwas und erhöhen dadurch das Verarbeitungszeitfenster.

Die JP 2009-135200 A beschreibt ebenfalls Vernetzer umfassend TAIC und verschiedene (Meth)acrylatderivate polyfunktioneller Alkohole, wobei in diesem Fall eine verbesserte Hitzebeständigkeit verbunden mit einer geringeren Tendenz zur Delamination der EVA-basierten Verkapselung beschrieben wird.

Die JP 2007-281135 A und die JP 2007-305634 A beschreiben Vernetzerkombinationen aus TAIC und Trimethylolpropantriacrylat ("TMPTA") zur Verwendung bei der Herstellung von mehrschichtigen co-extrudierten EVA-Verkapselungsfolien für Solarzellen.

Ähnliche Kombinationen von Vernetzern für Solarzellenverkapselungsfolien beschreiben z. B. die JP 2013-138094 A, JPH11-20094, JPH11-20095, JPH11-20096, JPH11-20097, JPH11-20098, JPH11-21541, CN 102391568 A, CN 102504715 A, CN 102863918 A, CN 102911612 A, CN 103045105 A, CN 103755876 A, CN 103804774 A, US 2011/0160383 A1, WO 2014/129573 A1.

Demnach besteht ein Bedürfnis hinsichtlich neuer Covernetzersysteme, insbesondere zur Herstellung von Verkapselungsfolien für Solarzellen, die im Vergleich zu Folien, die nach dem Stand der Technik vernetzt sind, zu einem deutlich erhöhten elektrischen Durchgangswiderstand führen, um so beim Einsatz in Photovoltaikmodulen zu einer Verringerung des PID-Risikos führen.

Aufgabe der vorliegenden Erfindung war es deshalb, neue Zusammensetzungen zur Verfügung zu stellen, die zur Herstellung von Folien mit möglichst hohem spezifischen elektrischen Durchgangswiderstands p verwendet werden können und sich somit besonders zur Verkapselung von elektronischen Vorrichtungen wie zum Beispiel Solarzellen eignen. Diese Zusammensetzungen sollten außerdem in den etablierten Prozessen einsetzbar sein und die Kosten der Folien nicht wesentlich erhöhen. Insbesondere sollten Sie nicht die Nachteile aufweisen, die bei den Covernetzersystemen des Standes der Technik, und hier insbesondere bei jenen in der CN 103525321 A genannten Zusammensetzungen, beobachtet werden.

Es wurde nun überraschend gefunden, dass mit Hilfe bestimmter Zusammensetzungen eine Verkapselungsfolie für Solarzellen erhalten werden kann, die diese Anforderungen erfüllt. Die hier gefundenen Zusammensetzungen erhöhen den Volumenwiderstand erheblich bei vergleichsweise kleinen Einsatzmengen, ohne andere Folieneigenschaften negativ zu beeinflussen. Die Folien haben eine exzellente Verarbeitbarkeit, eine hohe Transparenz und exzellente UV- und Wärmealterungseigenschaften.

### Detaillierte Beschreibung der Erfindung

Die Covernetzersysteme gemäß der vorliegenden Erfindung können überraschend zur Herstellung von Folien zur Verkapselung von elektronischen Vorrichtungen wie zum Beispiel Solarzellen mit einem hohen spezifischen Durchgangswiderstand verwendet werden.

Das erfindungsgemäße Covernetzersystem ist demnach eine Zusammensetzung **(A)** umfassend (i) mindestens eine Verbindung **(I)** ausgewählt aus der Gruppe bestehend aus Triallylisocyanurat, Triallylcyanurat, wobei die Verbindung **(I)** insbesondere Triallylisocyanurat ist; und

### (ii) mindestens eine Verbindung der chemischen Struktur (II) mit

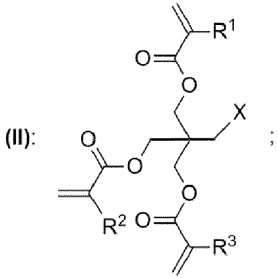

wobei X ausgewählt ist aus -H, -OH, unverzweigte oder verzweigte Alkylgruppe mit 1 bis 10, insbesondere 2 bis 10, Kohlenstoffatomen, einem Rest der chemischen Strukturen **(III), (IV)** mit 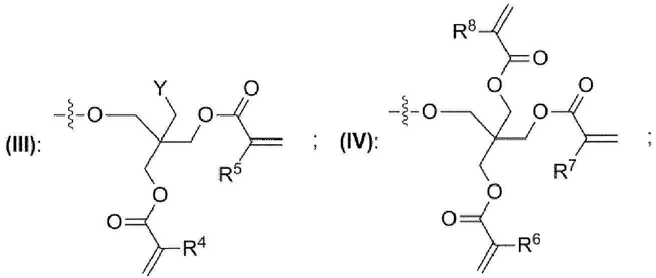 wobei Y ausgewählt ist aus -H, -OH, unverzweigte oder verzweigte Alkylgruppe mit 1 bis 10 Kohlenstoffatomen;
und wobei R¹, R², R³, R⁴, R⁵, R⁶, R⁷, R⁸ unabhängig voneinander jeweils Wasserstoff oder eine Methylgruppe ist.

Eine Verbindung der chemischen Struktur **(II)** wird im Sinne der Erfindung auch als "Pentaerythritolverbindung" bezeichnet.

Neben der überraschenden Erkenntnis, dass sich die Verbindungen der Struktur **(II)** zusammen mit mindestens einer Verbindung **(I)** als Covernetzersysteme zur Herstellung von Folien zur Verkapselung von elektronischen Vorrichtungen (zum Beispiel Solarzellen) eignen, wurde zusätzlich festgestellt, dass für jene Verbindungen **(II),** in welchen X = OH oder X einem Rest der chemischen Strukturen **(III), (IV)** entspricht, gegenüber jenen Verbindungen **(II),** in welchen X = Methyl ist, eine besonders starke Erhöhung des spezifischen Widerstandes der Folien erreicht werden kann.

Bevorzugt ist deshalb in der chemischen Struktur **(II)** X ausgewählt aus -OH, einem Rest der chemischen Strukturen **(III), (IV)** mit Y = OH, wobei R¹, R², R³, R⁴, R⁵, R⁶, R⁷, R⁸ unabhängig voneinander jeweils Wasserstoff oder eine Methylgruppe ist.

Noch bevorzugter ist in der chemischen Struktur **(II)** X ein Rest ausgewählt aus den chemischen Strukturen **(III), (IV)** mit Y = OH, wobei R¹, R², R³, R⁴, R⁵, R⁶, R⁷, R⁸ unabhängig voneinander jeweils Wasserstoff oder eine Methylgruppe ist.

In einer ersten noch bevorzugteren Ausführungsform ist in der chemischen Struktur **(II)** X ein Rest der chemischen Struktur **(III)** mit Y = OH, wobei R¹, R², R³, R⁴, R⁵ unabhängig voneinander jeweils Wasserstoff oder eine Methylgruppe ist. In dieser ersten noch bevorzugteren Ausführungsform hat die Verbindung der chemischen Struktur **(II)** demnach die Struktur **(V)** mit 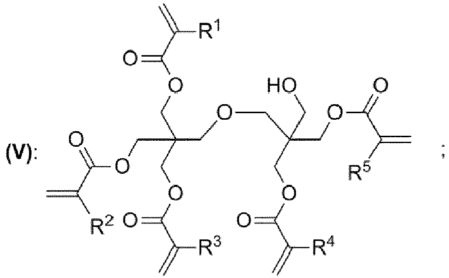 in der R¹, R², R³, R⁴, R⁵ unabhängig voneinander jeweils Wasserstoff oder eine Methylgruppe ist. Am bevorzugtesten sind dann R¹, R², R³, R⁴, R⁵ gleich und alle Wasserstoff oder alle Methyl.

In einer zweiten noch bevorzugteren Ausführungsform ist in der chemischen Struktur **(II)** X ein Rest der chemischen Struktur **(IV),** wobei R¹, R², R³, R⁶, R⁷, R⁸ unabhängig voneinander jeweils Wasserstoff oder eine Methylgruppe ist. In dieser zweiten noch bevorzugteren Ausführungsform hat die Verbindung der chemischen Struktur **(II)** demnach die Struktur **(VI)** mit 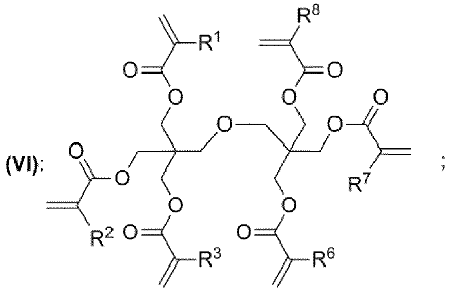 in der R¹, R², R³, R⁶, R⁷, R⁸ unabhängig voneinander jeweils Wasserstoff oder eine Methylgruppe ist. Am bevorzugtesten sind dann R¹, R², R³, R⁶, R⁷, R⁸ gleich und alle Wasserstoff oder alle Methyl.

Das Verhältnis der Menge an Verbindungen der chemischen Struktur **(II)** in der erfindungsgemäßen Zusammensetzung **(A)** zu den Verbindungen **(I)** in der erfindungsgemäßen Zusammensetzung **(A)** ist nicht besonders beschränkt. So ist eine Erhöhung des spezifischen Widerstandes insbesondere schon bei Zusatz geringer Mengen der Verbindungen der chemischen Struktur **(II)** feststellbar, zum Beispiel wenn in der Zusammensetzung **(A)** der Anteil an allen Verbindungen der chemischen Struktur **(II)** bezogen auf alle Verbindungen **(I)** bei 0.9 Mol.-% liegt. Im Hinblick auf den ökonomischen Einsatz der Verbindungen der chemischen Struktur **(II)** stellt andererseits ein Anteil an allen Verbindungen der chemischen Struktur **(II)** in der Zusammensetzung **(A)** bezogen auf alle Verbindungen **(I)** in der Zusammensetzung **(A)** von 21.0 Mol.-% eine bevorzugte Obergrenze dar.

Bevorzugte Bereiche für den Anteil an allen Verbindungen der chemischen Struktur **(II)** in der Zusammensetzung **(A)** bezogen auf alle Verbindungen **(I)** in der Zusammensetzung **(A)** liegen somit im Bereich 0.9 Mol.-% bis 21.0 Mol.-%, insbesondere 1.0 Mol.-% bis 12.5 Mol.-%, bevorzugt 1.5 Mol.-% bis 8.2 Mol.-%, bevorzugter 1.8 Mol.-% bis 5.4 Mol.-%, noch bevorzugter 2.0 Mol.-% bis 4.7 Mol.-% am bevorzugtesten bei 2.8 Mol.-% bis 3.1 Mol.-%.

In einer weiteren bevorzugten Ausführungsform der erfindungsgemäßen Zusammensetzung **(A)** umfasst diese als Verbindung **(I)** Triallylisocyanurat (= "TAIC") und als Verbindung der chemischen Struktur **(II)** Trimethylolpropantriacrylat ( = "TMPTA"), wobei dann insbesondere das molare Verhältnis von TMPTA zu TAIC in der Zusammensetzung **(A)** im Bereich 1.0 Mol.-% bis 21.0 Mol.-%, bevorzugt bei 5.4 Mol.-% liegt. TMPTA hat die chemische Struktur **(II)** mit R¹ = R² = R³ = H und X = Methyl.

In einer weiteren bevorzugten Ausführungsform der erfindungsgemäßen Zusammensetzung **(A)** umfasst diese als Verbindung **(I)** Triallylisocyanurat (= "TAIC") und als Verbindung der chemischen Struktur **(II)** Trimethylolpropantrimethacrylat ( = "TMPTMA"), wobei dann insbesondere das molare Verhältnis von TMPTMA zu TAIC in der Zusammensetzung **(A)** im Bereich 1.0 Mol.-% bis 8.2 Mol.-%, bevorzugt bei 1.5 Mol.-% bis 4.7 Mol.-% liegt, am bevorzugtesten bei 3.1 Mol.-%. TMPTMA hat die chemische Struktur **(II)** mit R¹ = R² = R³= X = Methyl.

In einer weiteren bevorzugten Ausführungsform der erfindungsgemäßen Zusammensetzung **(A)** umfasst diese als Verbindung **(I)** Triallylisocyanurat (= "TAIC") und als Verbindung der chemischen Struktur **(II)** mindestens eine Verbindung ausgewählt aus der Gruppe bestehend aus Dipentaerythritolpentaacrylat (= "Dipenta"), Dipentaerythritolhexaacrylat (= "Dihexa"). Dipenta hat die CAS-Nummer 60506-81-2 und die chemische Struktur **(V)** mit R¹ = R² = R³ = R⁴ = R⁵ = H. Dihexa hat die CAS-Nummer 29570-58-9 und die chemische Struktur **(VI)** mit R¹ = R² = R³ = R⁶ = R⁷ = R⁸ = H. Insbesondere ist dann das molare Verhältnis der Verbindung der chemischen Struktur **(II)** zu TAIC in der Zusammensetzung **(A)** im Bereich 0.9 Mol.-% bis 12.5 Mol.-%, bevorzugt bei 1.0 Mol.-% bis 3.1 Mol.-%, bevorzugter 1.8 Mol-% bis 2.8 Mol.-%, am bevorzugtesten 2.0 Mol.-%.

In einer weiteren bevorzugten Ausführungsform der erfindungsgemäßen Zusammensetzung **(A)** umfasst diese als Verbindung **(I)** Triallylisocyanurat (= "TAIC") und als Verbindung der chemischen Struktur **(II)** Dipenta, wobei dann insbesondere das molare Verhältnis von Dipenta zu TAIC in der Zusammensetzung **(A)** im Bereich 1.0 Mol.-% bis 12.5 Mol.-%, bevorzugt bei 2.0 Mol.-% bis 3.1 Mol.-% liegt.

In einer weiteren bevorzugten Ausführungsform der erfindungsgemäßen Zusammensetzung **(A)** umfasst diese als Verbindung **(I)** Triallylisocyanurat (= "TAIC") und als Verbindung der chemischen Struktur **(II)** Dihexa, wobei dann insbesondere das molare Verhältnis von Dihexa zu TAIC in der Zusammensetzung **(A)** im Bereich 0.9 Mol.-% bis 2.8 Mol.-%, bevorzugt bei 1.8 Mol.-% liegt.

Die vorliegenden Covernetzersysteme werden bevorzugt zur Herstellung von Folien zur Verkapselung von elektronischen Vorrichtungen, z. B. Solarzellen in PV-Modulen, verwendet.

Dabei werden die Covernetzersysteme typischerweise zusammen mit Polyolefincopolymeren eingesetzt.

Die vorliegende Erfindung betrifft demnach auch eine Zusammensetzung **(B)** umfassend mindestens ein Polyolefincopolymer und die erfindungsgemäße Zusammensetzung **(A).**

Erfindungsgemäß einsetzbare Polyolefincopolymere sind dem Fachmann bekannt und etwa in der WO 2008/036708 A2 und der JP 2012-087260 beschrieben.

Insbesondere werden erfindungsgemäß als Polyolefincopolymere Ethylen/ α-Olefin-Interpolymere eingesetzt, wobei der Begriff "Interpolymer" bedeutet, dass das betreffende Polyolefincopolymer aus mindestens zwei verschiedenen Monomeren hergestellt wurde. Somit schließt der Begriff "Interpolymer" insbesondere Polyolefincopolymere aus genau zwei Monomereinheiten, aber auch Terpolymere (zum Beispiel Ethylen/Propylen/1-Octen, Ethylen/Propylen/Buten, Ethylen/Buten/1-Octen, Ethylen/Buten/Styrol) und Tetrapolymere ein.

Als Polyolefincopolymere kommen erfindungsgemäß insbesondere Ethylen/ α-Olefin-Copolymere, die bevorzugt neben Ethylen und dem α-Olefin keine weiteren Monomereinheiten aufweisen, in Frage, wobei im Sinne der Erfindung das "α-Olefin" bevorzugt ausgewählt ist aus der Gruppe bestehend aus Propen, 1-Buten, 4-Methyl-1-Penten, 1-Hexen, 1-Octen, 1-Decen, 1-Dodecen, 1-Tetradecen, 1-Hexadecen, 1-Octadecen, 3-Cyclohexyl-1-propen, Vinylcyclohexan, Acrylsäure, Methacrylsäure, Norbornen, Styrol, Methylstyrol, Vinylacetat.

Noch bevorzugter ist das erfindungsgemäße Polyolefincopolymer in der Zusammensetzung **(B)** ein Ethylen-Vinylacetat-Copolymer.

Werden als Polyolefincopolymere Ethylen/ α-Olefin-Interpolymere eingesetzt, so weisen diese insbesondere einen α-Olefin-Gehalt im Bereich 15 bis 50 Gew.-%, bezogen auf das Gesamtgewicht des Ethylen/ α-Olefin-Interpolymers, auf. Bevorzugt liegt der α-Olefin-Gehalt im Bereich 20 bis 45 Gew.-%, bevorzugter im Bereich 25 bis 40 Gew.-%, noch bevorzugter 26 bis 34 Gew.-%, am bevorzugtesten 28 bis 33 Gew.-%, jeweils bezogen auf das Gesamtgewicht des Ethylen/ α-Olefin-Interpolymers.

In der bevorzugten Ausführungsform, in welcher es sich bei dem Polyolefincopolymer um ein Ethylen-Vinylacetat-Copolymer handelt, weist das Ethylen-Vinylacetat-Copolymer insbesondere einen Vinylacetat-Gehalt im Bereich 15 bis 50 Gew.-%, bezogen auf das Gesamtgewicht des Ethylen-Vinylacetat-Copolymers, auf. Bevorzugt liegt der Vinylacetat-Gehalt dann im Bereich 20 bis 45 Gew.-%, bevorzugter im Bereich 25 bis 40 Gew.-%, noch bevorzugter 26 bis 34 Gew.-%, am bevorzugtesten 28 bis 33 Gew.-% jeweils bezogen auf das Gesamtgewicht des Ethylen-Vinylacetat-Copolymers.

Der α-Olefin-Gehalt, insbesondere im Falle des Ethylen/ Vinylacetat-Copolymer der Gehalt an Vinylacetat, wird dabei mit dem in ASTM D 5594:1998 ["Bestimmung des Vinylacetatgehalts von Ethylenvinylacetat(EVA)-Copolymeren mit Hilfe der Fourier-Transformations-Infrarotspektroskopie"] beschriebenen Verfahren bestimmt.

Der Anteil der von der Zusammensetzung **(B)** umfassten Zusammensetzung **(A)** ist dabei nicht besonders beschränkt. Der Anteil der Zusammensetzung **(A)** in der Zusammensetzung **(B)** liegt insbesondere im Bereich von 0.05 bis 10 Gew.-%, bevorzugt im Bereich von 0.1 bis 5 Gew.-%, bevorzugter im Bereich von 0.2 bis 3 Gew.-%, noch bevorzugter bei 0.3 bis 1 Gew.-%, besonders bevorzugt bei 0.5 Gew-%, jeweils bezogen auf die Masse aller von der Zusammensetzung **(B)** umfassten Polyolefincopolymere.

Die Zusammensetzung **(B)** eignet sich erfindungsgemäß zur Herstellung einer Verkapselungsfolie für elektronische Vorrichtungen, zum Beispiel Solarzellen. Sie wird dazu bei der Solarmodul-Lamination einer Vernetzungsreaktion unterzogen.

Zum Start der Vernetzungsreaktion ist es üblich, Initiatoren einzusetzen, also durch Wärme, Licht, Feuchtigkeit oder Elektronenstrahlen aktivierbare Radikalbildner.

In einer bevorzugten Ausführungsform der vorliegenden Erfindung umfasst die Zusammensetzung **(B)** deshalb auch einen Initiator ausgewählt aus der Gruppe bestehend aus peroxidischen Verbindungen, Azoverbindungen, Photoinitiatoren. Bevorzugter ist der Initiator ausgewählt aus der Gruppe bestehend aus peroxidischen Verbindungen, Azoverbindungen. Beispiele dafür sind in der *"*Encyclopedia of Chemical Technology 1992, 3rd Edition, Vol. 17, Seiten 27- 90*"* beschrieben.

Peroxidische Verbindungen sind insbesondere organische Peroxide, welche wiederum ausgewählt sind aus der Gruppe bestehend aus Dialkylperoxiden, Diperoxyketalen, Peroxycarbonsäureestern, Peroxycarbonaten.

Dialkylperoxide sind insbesondere ausgewählt aus der Gruppe bestehend aus Dicumylperoxid, Di-*tert*-butylperoxid, Di-*tert*-Hexylperoxid, *tert*-Butylcumylperoxid, *iso*-Propylcumyl-*tert*-butylperoxid, *tert*-Hexylcumylperoxid, 2,5-Dimethyl-2,5-di(*tert*-butylperoxy)-hexan, 2,5-Dimethyl-2,5-di(*tert*-amylperoxy)-hexan, 2,5-Dimethyl-2,5-di(*tert*-butylperoxy)-hex-3-in, 2,5-Dimethyl-2,5-di(*tert*-amylperoxy)-hex-3-in, α,α-Di[(*tert*-butylperoxy)-*iso*-propyl]-benzol, Di-*tert*-amylperoxid, 1,3,5-Tri-[(*tert*-butylperoxy)-isopropyl]-benzol, 1,3-Dimethyl-3-(*tert*-butylperoxy)-butanol, 1,3-dimethyl-3-(*tert*-amylperoxy)-butanol, *iso*-Propylcumylhydroperoxid.

Diperoxyketale sind insbesondere ausgewählt aus der Gruppe bestehend aus 1,1-Di(*tert*-butylperoxy)-3,3,5-trimethylcyclohexan, 1,1-Di(*tert*-amylperoxy)-cyclohexan, 1,1-Di(*tert*-butylperoxy)-cyclohexan, *n*-Butyl-4,4-di(*tert*-amylperoxy)-valerat, Ethyl-3,3-di(*tert*-butylperoxy)-butyrat, 2,2-Di(*tert*-butylperoxy)butan, 3,6,6,9,9-Pentamethyl-3-ethoxycarbonylmethyl-1,2,4,5-tetraoxacyclononan, 2-2-Di(*tert*-amylperoxy)-propan, *n*-Butyl-4-4-bis(*tert*-butylperoxy)-valerat.

Peroxycarbonsäureester sind insbesondere ausgewählt aus der Gruppe bestehend aus *tert*-Amylperoxyacetat, *tert*-Butylperoxy-3,5,5-trimethylhexanoat, *tert*-Amylperoxybenzoat, *tert*-Butylperoxyacetat, *tert*-Butylperoxybenzoat, *OO*-*tert*-Butylmonoperoxysuccinat, *OO*-*tert*-Amylmonoperoxysuccinat.

Peroxycarbonate sind insbesondere ausgewählt aus der Gruppe bestehend aus *tert*-Butylperoxy-2-ethylhexylcarbonat, *tert*-Butylperoxy-*iso*-propylcarbonat, *tert*-Amylperoxy-2-ethylhexyl-carbonat, *tert*-Amylperoxybenzoat. Ein bevorzugtes Peroxycarbonat ist *tert*-Butylperoxy-2-ethylhexylcarbonat ("TBPEHC").

Die Azoverbindung ist bevorzugt ausgewählt aus der Gruppe bestehend aus 2,2'-Azobis-(2-acetoxypropan), 1,1'-Azodi(hexahydrobenzonitril).

Besonders bevorzugt ist der Initiator ausgewählt aus der Gruppe bestehend aus 2,5-Dimethyl-2,5-di(*tert*-butylperoxy)-hexan, *tert*-Butylperoxy-2-ethylhexylcarbonat, *tert*-Butylperoxy-3,5,5-trimethylhexanoat, 1,1-Di(*tert*-butylperoxy)-3,5,5-trimethylcyclohexan, *tert*-Amylperoxy-2-ethylhexylcarbonat; am bevorzugtesten ist der Initiator *tert*-Butylperoxy-2-ethylhexylcarbonat ("TBPEHC").

Die Masse der peroxidischen Verbindung oder der Azoverbindung, bevorzugt der peroxidischen Verbindung, welche bezogen auf die Masse des Polyolefincopolymers eingesetzt wird, ist nicht besonders beschränkt. Die peroxidische Verbindung oder die Azoverbindung, bevorzugt die peroxidische Verbindung, wird insbesondere in einer Menge von 0.05 bis 10 Gew.-%, bevorzugt 0.1 bis 5 Gew.-%, bevorzugter 0.5 bis 2 Gew.-%, jeweils bezogen auf die Masse aller von der Zusammensetzung **(B)** umfassten Polyolefincopolymere, eingesetzt.

Photoinitiatoren sind insbesondere ausgewählt aus der Gruppe bestehend aus Benzophenon, Benzanthron, Benzoin, Benzoinalkylether, 2,2-Diethoxyacetophenon, 2,2-Dimethoxy-2-phenylacetophenon, *p*-Phenoxydichloracetophenon, 2-Hydroxycyclohexylphenon, 2-Hydroxyisopropylphenon, 1-Phenylpropandion-2-(ethoxycarbonyl)-oxim.

Der Photoinitiator wird insbesondere in einer Menge von 0.05 bis 10 Gew.-%, bevorzugt 0.1 bis 5 Gew.-%, bevorzugter 0.2 bis 3 Gew.-%, noch bevorzugter 0.25 bis 1 Gew.-%, jeweils bezogen auf die Masse aller von der Zusammensetzung **(B)** umfassten Polyolefincopolymere, eingesetzt.

In einer weiteren bevorzugten Ausführungsform der vorliegenden Erfindung umfasst die Zusammensetzung **(B)** auch mindestens eine weitere Verbindung ausgewählt aus der Gruppe bestehend aus Vernetzern, Silankupplungsmitteln, Antioxidantien, Alterungsschutzmittel, Metalloxiden, Metallhydroxiden, Weißpigmenten; wobei als weitere Verbindung besonders bevorzugt Silankupplungsmittel eingesetzt werden.

Der Begriff "weitere Verbindung" impliziert dabei im Sinne der Erfindung, dass es sich bei dieser Verbindung nicht um Triallylisocyanurat, Triallylcyanurat oder eine Verbindung der chemischen Struktur **(II)** handelt.

Vernetzer sind dabei bevorzugt ausgewählt aus der Gruppe bestehend aus Divinylbenzol, Ethylenglycoldi(meth)acrylat, Diethylenglycoldi(meth)acrylat, Polyethylenglycoldi(meth)acrylat, Neopentylglycoldi(meth)acrylat, 1,6-Hexandioldi(meth)acrylat, 1,9-Nonandioldi(meth)acrylat, 1,10-Decandioldi(meth)acrylat.

Der Anteil der von der Zusammensetzung **(B)** umfassten Vernetzer ist dabei nicht besonders beschränkt. Der Anteil der Vernetzer in der Zusammensetzung **(B)** liegt insbesondere bei 0.005 bis 5 Gew.-% bevorzugt 0.01 bis 3 Gew.-% bevorzugter 0.05 bis 3 Gew.-%, noch bevorzugter 0.1 bis 1.5 Gew.-%, jeweils bezogen auf die Masse aller von der Zusammensetzung **(B)** umfassten Polyolefincopolymere.

Als erfindungsgemäß in der Zusammensetzung **(B)** einsetzbare Silankupplungsmittel kommen alle Silane in Betracht, welche einen ungesättigten Kohlenwasserstoffrest und einen hydrolysierbaren Rest aufweisen (beschrieben etwa in EP 2 436 701 B1, US 5,266,627).

Ungesättigte Kohlenwasserstoffreste sind insbesondere ausgewählt aus der Gruppe bestehend aus Vinyl, Allyl, Isopropenyl, Butenyl, Cyclohexenyl, γ-(Meth)acryloxyallyl.

Hydrolisierbarer Reste sind insbesondere ausgewählt aus der Gruppe bestehend aus Hydrocarbyloxy, Hydrocarbonyloxy, Hydrocarbylamino. Bevorzugt ist der hydrolysierbare Rest ausgewählt aus der Gruppe bestehend aus Methoxy, Ethoxy, Formyloxy, Acetoxy, Proprionyloxy, Alkylamino, Arylamino.

Bevorzugt ist das Silankupplungsmittel ausgewählt aus der Gruppe bestehend aus: Vinyltriethoxysilan, Vinyltris-(β-methoxyethoxy)silan, Vinyltriacetoxysilan, γ-Acryloxypropyltrimethoxysilan, γ-Methacryloxypropyltrimethoxysilan, *N*-(β-aminoethyl)-γ-aminopropyltrimethoxysilan, *N*-(β-Aminoethyl)-γ-aminopropylmethyldimethoxysilan, γ-Aminopropyltriethoxysilan, γ-Glycidoxypropyltrimethoxysilan, γ-Mercaptopropyltriethoxysilan, γ-Chlorpropyltrimetoxysilan, β-(3,4-Ethoxycyclohexyl)-ethyltrimethoxysilan, γ-Mercaptopropyltrimethoxysilan. Besonders bevorzugt wird als Silankupplungsmittel γ-Methacryloxypropyltrimethoxysilan (abgekürzt als "KBM") eingesetzt.

Der Anteil des von der Zusammensetzung **(B)** umfassten Silankupplungsmittels ist dabei nicht besonders beschränkt. Der Anteil aller von der Zusammensetzung **(B)** umfassten Silankupplungsmittel liegt insbesondere bei 0.05 bis 5 Gew.-%, bevorzugt 0.1 bis 2 Gew.-%, jeweils bezogen auf die Masse aller von der Zusammensetzung **(B)** umfassten Polyolefincopolymere.

Antioxidantien sind im Sinne der Erfindung bevorzugt ausgewählt aus der Gruppe bestehend aus phenolischen Antioxidantien, phosphorhaltigen Antioxidantien.

Phenolische Antioxidantien sind insbesondere ausgewählt aus der Gruppe bestehend aus 4-Methoxyphenol, 2,6-Di-*tert*-butyl-4-methylphenol, *tert*-Butylhydrochinon, Stearyl-β-(3,5-di-*tert*-butyl-4-hydroxyphenyl)-propionat, Pentaerythrittetrakis-[3-(3,5-di-*tert*-butyl-4-hydroxyphenyl)-propionat], 3,5-Di-*tert*-butyl-4-hydroxybenzoësäurehexadecylester.

Phosphorhaltige Antioxidantien sind insbesondere ausgewählt aus der Gruppe bestehend aus Triphenylphosphit, Tris-(nonylphenyl)-phosphit, Distearylpentaerythritoldiphosphit, Tetra-(tridecyl)-1,1,3-tris-(2-methyl-5-*tert*-butyl-4-hydroxyphenyl)-butan-diphosphat, Tetrakis-(2,4-di-*tert*-butylphenyl)-4,4-biphenyldiphosphonit.

Der Anteil der von der Zusammensetzung **(B)** umfassten Antioxidantien ist dabei nicht besonders beschränkt. Der Anteil aller von der Zusammensetzung **(B)** umfassten Antioxidantien liegt insbesondere bei 0.01 bis 0.5 Gew.-%, bevorzugt 0.05 bis 0.3 Gew.-%, jeweils bezogen auf die Masse aller von der Zusammensetzung **(B)** umfassten Polyolefincopolymere.

Alterungsschutzmittel sind im Sinne der Erfindung insbesondere ausgewählt aus der Gruppe *der"hindered amine light stabilizers"* (= "HALS")-Stabilisatoren und der UV-Absorber. HALS-Stabilisatoren sind im Sinne der Erfindung insbesondere Verbindungen, die mindestens einen 2,2,6,6-Tetramethyl-4-piperidyl-Rest aufweisen, wobei das Stickstoffatom an der 1-Position des Piperidylrestes ein H, eine Alkylgruppe oder eine Alkoxygruppe trägt.

Bevorzugt sind HALS-Stabilisatoren ausgewählt aus der Gruppe bestehend aus Bis(2,2,6,6-tetramethyl-4-piperidyl)-sebacat, 1,2,2,6,6-Pentamethyl-4-piperidylsebacat, Bis(1,2,2,6,6-pentamethyl-4-piperidyl)-sebacat, Bis-(1-octyloxy-2,2,6,6-tetramethyl-4-piperidyl)-sebacat, Poly-{(6-morpholino-S-triazin-2,4-diyl)-[2,2,6,6-tetramethyl-4-piperidyl)-imino]- hexamethylen-[(2,2,6 ,6-tetramethyl-4-piperidyl)-imino]} mit der CAS-Nummer 82451-48-7, Polymere der CAS-Nummer 193098-40-7, Copolymer aus Dimethylsuccinat und 1-(2-Hydroxyethyl)-2,2,6,6-tetramentyl-4-piperidinol, *N*,*N',N",N"'-*Tetrakis-{4,6-bis-[butyl-(*N*-methyl-2,2,6,6-tetramethylpiperidin-4-yl)-amino]-triazin-2-yl}-4,7-diazadecan-1,10-diamin mit der CAS-Nummer 106990-43-6.

Der Anteil der von der Zusammensetzung **(B)** umfassten HALS-Stabilisatoren ist dabei nicht besonders beschränkt. Der Anteil aller von der Zusammensetzung **(B)** umfassten HALS-Stabilisatoren liegt insbesondere bei 0.01 bis 0.5 Gew.-%, bevorzugt 0.05 bis 0.3 Gew.-%, jeweils bezogen auf die Masse aller von der Zusammensetzung **(B)** umfassten Polyolefincopolymere.

UV-Absorber sind insbesondere ausgewählt aus der Gruppe bestehend aus 2-Hydroxy-4-*N*-octoxybenzophenon, 2,4-Di-*tert*-butylphenyl-3,5-di-*tert*-butyl-4-hydroxybenzoat, 2-Hydroxy-4-methoxybenzophenon, 2,2-Dihydroxy-4-methoxybenzophenon, 2-Hydroxy-4-methoxy-4-carboxybenzophenon, 2-(2-Hydroxy-3,5-di-*tert*-butylphenyl)-benzotriazol, 2-(2-Hydroxy-5-methylphenyl)-benzotriazol, p-Octyl-phenyl salicylat, 2-(4,6-Diphenyl-1,3,5-triazine-2-yl)-5-[(hexyl)-oxy]-phenol, Ethyl-2-cyano-3,3-diphenyl-acrylat.

Der Anteil der von der Zusammensetzung **(B)** umfassten UV-Absorber ist dabei nicht besonders beschränkt. Der Anteil aller von der Zusammensetzung **(B)** umfassten UV-Absorber liegt insbesondere bei 0.01 bis 0.5 Gew.-%, bevorzugt 0.05 bis 0.3 Gew.-%, jeweils bezogen auf die Masse aller von der Zusammensetzung **(B)** umfassten Polyolefincopolymere.

Metalloxide sind erfindungsgemäß insbesondere ausgewählt aus der Gruppe bestehend aus Alkalimetalloxiden, Erdalkalimetalloxiden, Zinkoxid, bevorzugt ausgewählt aus der Gruppe bestehend aus Magnesiumoxid, Zinkoxid.

Der Anteil der von der Zusammensetzung **(B)** umfassten Metalloxide ist dabei nicht besonders beschränkt. Der Anteil aller von der Zusammensetzung **(B)** umfassten Metalloxide liegt insbesondere bei 0.01 bis 10 Gew.-%, bevorzugt 0.05 bis 3 Gew.-%, jeweils bezogen auf die Masse aller von der Zusammensetzung **(B)** umfassten Polyolefincopolymere.

Metallhydroxide sind erfindungsgemäß insbesondere ausgewählt aus der Gruppe bestehend aus Alkalimetallhydroxiden, Erdalkalimetallhydroxiden, bevorzugt ausgewählt aus der Gruppe bestehend aus Magnesiumhydroxid, Calciumhydroxid.

Der Anteil der von der Zusammensetzung **(B)** umfassten Metallhydroxide ist dabei nicht besonders beschränkt. Der Anteil aller von der Zusammensetzung **(B)** umfassten Metallhydroxide liegt insbesondere bei 0.01 bis 10 Gew.-%, bevorzugt 0.05 bis 3 Gew.-%, jeweils bezogen auf die Masse aller von der Zusammensetzung **(B)** umfassten Polyolefincopolymere.

Weißpigmente sind im Sinne der Erfindung insbesondere ausgewählt aus der Gruppe Titandioxid, Zinkoxid, Zinksulfid, Bariumsulfat, Lithopone.

Der Anteil der von der Zusammensetzung **(B)** umfassten Weißpigmente ist dabei nicht besonders beschränkt. Der Anteil aller von der Zusammensetzung **(B)** Weißpigmente liegt insbesondere bei 5 bis 25 Gew.-%, bevorzugt 10 bis 20 Gew.-%, noch bevorzugter bei 15 Gew.-%, jeweils bezogen auf die Masse aller von der Zusammensetzung **(B)** umfassten Polyolefincopolymere.

Die Polymerzusammensetzung **(B)** wird in einem weiteren Aspekt der vorliegenden Erfindung zur Herstellung einer Folie zur Verkapselung einer elektronischen Vorrichtung, insbesondere einer Solarzelle, verwendet.

Dabei wird die Zusammensetzung **(B)** zunächst durch Mischen der Zusammensetzung **(A)** sowie den jeweiligen Additiven und dem Polyolefincopolymer hergestellt. Dies erfolgt insbesondere durch Zugabe der Additive in flüssiger Form, d.h. rein oder als Lösung in einem Lösungsmittel, zu der Zusammensetzung **(B)** in einem Mischer. Danach wird so lange gerührt oder die Mischung in Bewegung gehalten, bis die Flüssigkeit vollständig vom Polymergranulat absorbiert worden ist. Eventuell verwendete Lösemittel werden dann wieder durch Anlegen eines Vakuums entfernt.

In einem zweiten Schritt wird die Polymerformulierung über einen Extruder zu einem Film extrudiert. Hierbei wird die Zusammensetzung **(B)** kontinuierlich über eine Dosierschnecke in einen Extruder dosiert in dem das Poymer aufschmilzt und die Additive durch das Kneten der Mischung homogen in der Polymermatrix verteilt werden. Am Ende des Extruders wird die Schmelze durch eine Breitschlitzdüse gepresst. Nach der Düse wird die Folie durch ein Walzwerk abgezogen, nachgekühlt und aufgewickelt.

Alternativ können die Additive oder die Additivmischung auch direkt über den Einfüllstutzen oder über eine Seitendosierung in den Filmextruder dosiert werden.
Die nachfolgenden Beispiele sollen die vorliegende Erfindung weiter erläutern, ohne dass diese auf diese Beispiele beschränkt sein soll.

### Beispiele

### Verwendete Abkürzungen

Trimethylolpropantriacrylat = TMPTA; Trimethylolpropantrimethacrylat = TMPTMA; Dipentaerythritolpentaacrylat = Dipenta; Dipentaerythritolhexaacrylat = Dihexa; Triallylisocyanurat = TAIC; γ-Methacryloxypropyltrimethoxysilan = KBM.

### Verwendete Chemikalien

TMPTA (CAS: 15625-89-5) wurde bezogen von Alfa Aesar.

Dipentaerythritolpentaacrylat (CAS: 60506-81-2) wurde bezogen von Sartomer-Arkema.

Dipentaerythritolhexaacrylat (CAS: 29570-58-9) wurde bezogen von Shin Nakamura Chemical Co.,Ltd.

Bei dem im Folgenden verwendeten Triallylisocyanurat handelte es sich um "TAICROS ®" der Evonik Industries AG.

Bei dem im Folgenden verwendeten TMPTMA (CAS: 3290-92-4) handelt es sich um "TRIM" der Evonik Industries AG.

Bei dem im Folgenden verwendeten γ-Methacryloxypropyltrimethoxysilan handelte es sich um "Dynasylan Memo ®" der Evonik Industries AG.

Bei dem im Folgenden verwendeten EVA handelte es sich um "EVATANE 28-40" ® von Arkema mit einem Gehalt an Vinylacetat von 28.3 Gew.-%.

Das im Folgenden verwendete *tert*-Butylperoxy-2-ethylhexylcarbonat (="TBPEHC") wurde von der Firma United Initiators bezogen.

### 1. Herstellung des EVA-Granulats

### Vergleichsbeispiel V1

2.5 g (10.0 mmol) TAIC, 0.5 g KBM und 4.0 g TBPEHC wurden homogen vermischt. Diese Mischung wurde auf 493 g EVA gleichmäßig verteilt. Die EVA-Additivmischung wurde anschließend für 2 bis 4 h in einem Taumelmischer durchmischt.

### Beispiel 1

Eine Mischung aus 0.15 g (0.51 mmol) TMPTA, 2.35 g (9.43 mmol) TAIC, 0.5 g KBM und 4.0 g TBPEHC wurde auf 493 g EVA gleichmäßig verteilt. Die EVA-Additivmischung wurde anschließend für 2 bis 4 h in einem Taumelmischer durchmischt.

### Beispiel 2

Eine Mischung aus 0.5 g (1.69 mmol) TMPTA, 2.0 g (8.03 mmol) TAIC, 0.5 g KBM und 4.0 g TBPEHC wurde auf 493 g EVA gleichmäßig verteilt. Die EVA-Additivmischung wurde anschließend für 2 bis 4 h in einem Taumelmischer durchmischt.

### Beispiel 3

Eine Mischung aus 0.05 g (0.15 mmol) TMPTMA, 2.45 g (9.83 mmol) TAIC, 0.5 g KBM und 4.0 g wurde auf 493 g EVA gleichmäßig verteilt. Die EVA-Additivmischung wurde anschließend für 2 bis 4 h in einem Taumelmischer durchmischt.

### Beispiel 4

Eine Mischung aus 0.1 g (0.3 mmol) TMPTMA, 2.4 g (9.63 mmol) TAIC, 0.5 g KBM und 4.0 g TBPEHC wurde auf 493 g EVA gleichmäßig verteilt. Die EVA-Additivmischung wurde anschließend für 2 bis 4 h in einem Taumelmischer durchmischt.

### Beispiel 5

Eine Mischung aus 0.25 g (0.74 mmol) TMPTMA, 2.25 g (9.03 mmol) TAIC, 0.5 g KBM und 4.0 g TBPEHC wurde auf 493 g EVA gleichmäßig verteilt. Die EVA-Additivmischung wurde anschließend für 2 bis 4 h in einem Taumelmischer durchmischt.

### Beispiel 6

Eine Mischung aus 0.05 g (0.1 mmol) Dipenta, 2.45 g (9.83 mmol) TAIC, 0.5 g KBM und 4.0 g TBPEHC wurde auf 493 g EVA gleichmäßig verteilt. Die EVA-Additivmischung wurde anschließend für 2 bis 4 h in einem Taumelmischer durchmischt.

### Beispiel 7

Eine Mischung aus 0.1 g (0.19 mmol) Dipenta, 2.4 g (9.63 mmol) TAIC, 0.5 g KBM und 4.0 g TBPEHC wurde auf 493 g EVA gleichmäßig verteilt. Die EVA-Additivmischung wurde anschließend für 2 bis 4 h in einem Taumelmischer durchmischt.

### Beispiel 8

Eine Mischung aus 0.15 g (0.29 mmol) Dipenta, 2.35 g (9.43 mmol) TAIC, 0.5 g KBM und 4.0 g TBPEHC wurde auf 493 g EVA gleichmäßig verteilt. Die EVA-Additivmischung wurde anschließend für 2 bis 4 h in einem Taumelmischer durchmischt.

### Beispiel 9

Eine Mischung aus 0.5 g (1.0 mmol) Dipenta, 2.0 g (8.03 mmol) TAIC, 0.5 g KBM und 4.0 g TBPEHC wurde auf 493 g EVA gleichmäßig verteilt. Die EVA-Additivmischung wurde anschließend für 2 bis 4 h in einem Taumelmischer durchmischt.

### Beispiel 10

Eine Mischung aus 0.05 g (0.09 mmol) Dihexa, 2.45 g (9.83 mmol) TAIC, 0.5 g KBM und 4.0 g TBPEHC wurde auf 493 g EVA gleichmäßig verteilt. Die EVA-Additivmischung wurde anschließend für 2 bis 4 h in einem Taumelmischer durchmischt.

### Beispiel 11

Eine Mischung aus 0.1 g (0.17 mmol) Dihexa, 2.4 g (9.63 mmol) TAIC, 0.5 g KBM und 4.0 g TBPEHC wurde auf 493 g EVA gleichmäßig verteilt. Die EVA-Additivmischung wurde anschließend für 2 bis 4 h in einem Taumelmischer durchmischt.

### Beispiel 12

Eine Mischung aus 0.15 g (0.26 mmol) Dihexa, 2.35 g (9.43 mmol) TAIC, 0.5 g KBM und 4.0 g TBPEHC wurde auf 493 g EVA gleichmäßig verteilt. Die EVA-Additivmischung wurde anschließend für 2 bis 4 h in einem Taumelmischer durchmischt.

### 2. Folienextrusion

Zur Herstellung der EVA-Folien wurde das konditionierte EVA-Granulat, welches wie in den Beispielen V1, 1 - 12 hergestellt worden war, volumetrisch in einem Doppelschnecken-Laborextruder (Collin) dosiert. Die EVA-Schmelze wurde über eine Breitschlitzdüse (10 cm) mit einstellbarer Spaltdicke verdüst, die Folie kontinuierlich auf einem Walzwerk auf 20 °C mit Wasser nachgekühlt und anschließend aufgewickelt. Die Extrudereinstellungen sind nachstehend aufgeführt:

### Extrusionsparameter für EVA-Folienherstellung

| Temperatur Heizzonen [°C] | |
|---|---|
| T1 | 70 |
| T2 | 77 |
| T3 | 77 |
| T4 | 75 |
| T5 | 80 |
| Düse | 80 |

### 3. Folienlamination

Die Lamination der EVA-Folie wurde bei 150 °C (Maschineneinstellung) zwischen Teflontrennfolien durchgeführt, wobei die entsprechende Temperatur über den gesamten Laminationsprozess konstant gehalten wurde. Die Dauer des einstufigen Entgasungsschrittes betrug 100 s. Anschließend wurde die Probe mit einem Anpressdruck von 0.7 kg/cm² verpresst. Die Verweilzeit im Laminator betrug 20 Minuten.

### 4. Bestimmung des spezifischen Widerstands ρ

Für die Bestimmung des Widerstandes von vernetzten, 400 bis 500 µm starken EVA Folien wurden zunächst Proben mit den Abmaßen ca. 8 x 8 cm bei Raumtemperatur (22.5 °C) und einer relativen Luftfeuchte von 50 % für 7 Tage gelagert, um ein konstantes Feuchtigkeitslevel innerhalb des EVA Films zu gewährleisten.

Die Widerstandsmessung wurde mit einem Ohmmeter der Firma Keithley (6517B) und einer entsprechenden Messzelle, ebenfalls von Keithley *("resistivity test fixture 8009"),* durchgeführt. Nach ASTM D-257 wurde die Probe mit einer Spannung von 500 V für 60 s beaufschlagt und nach dieser Zeit der Strom gemessen. Der Widerstand p (VR) lässt sich dann aus den bekannten Größen berechnen.

Die folgende Tabelle 1 fasst die beobachteten Ergebnisse zusammen.

**Tabelle 1**

| Beispiel Nr. | TAIC [mmol] | Co-crosslinker | Co-crosslinker [mmol] | Anteil Co-Crosslinker bezogen auf TAIC [mol.-%] | VR * 10¹⁵ [Ohm*cm] |
|---|---|---|---|---|---|
| V1 | 10.0 | | | | 3.77 |
| 1 | 9.43 | TMPTA | 0.51 | 5.4 | 4.87 |
| 2 | 8.03 | TMPTA | 1.69 | 21.0 | 6.19 |
| 3 | 9.83 | TMPTMA | 0.15 | 1.5 | 4.27 |
| 4 | 9.63 | TMPTMA | 0.3 | 3.1 | 3.55 |
| 5 | 9.03 | TMPTMA | 0.74 | 8.2 | 2.78 |
| 6 | 9.83 | Dipenta | 0.1 | 1.0 | 5.07 |
| 7 | 9.63 | Dipenta | 0.19 | 2.0 | 5.67 |
| 8 | 9.43 | Dipenta | 0.29 | 3.1 | 7.94 |
| 9 | 8.03 | Dipenta | 1.0 | 12.5 | 9.91 |
| 10 | 9.83 | Dihexa | 0.09 | 0.9 | 6.4 |
| 11 | 9.63 | Dihexa | 0.17 | 1.8 | 8.61 |
| 12 | 9.43 | Dihexa | 0.26 | 2.8 | 6.21 |

Die in der Tabelle 1 dargestellten Ergebnisse belegen, dass die Kombination aus TAIC und Verbindungen der allgemeinen chemischen Struktur **(II)** eine deutliche Erhöhung des spezifischen Widerstandes gegenüber dem Einsatz von TAIC als einzigen Vernetzer ergibt.

Zusätzlich dazu zeigen die Ergebnisse gemäß Tabelle 1, dass eine zusätzliche deutliche Verbesserung beobachtet werden kann, wenn Verbindungen gemäß der chemischen Struktur **(II),** in welcher X ein Rest der chemischen Struktur **(III)** oder **(IV)** ist (wie es für Dipenta bzw. Dihexa der Fall ist) anstatt TMPTA und TMPTMA, also Verbindungen gemäß der chemischen Struktur **(II),** in welcher X = H ist, eingesetzt werden. Dies geht aus einem Vergleich der in den Beispielen 1 bis 5 gemessenen VR-Werte mit den in den Beispielen 6 bis 12 gemessenen VR-Werten hervor. Die mit Dipenta und Dihexa gemessenen Werte sind allesamt relativ höher als die für TMPTA und TMPTMA gemessenen Werte.

## Patentansprüche

1. Zusammensetzung **(A)** umfassend
(i) mindestens eine Verbindung **(I)** ausgewählt aus der Gruppe bestehend aus Triallylisocyanurat, Triallylcyanurat; und
(ii) mindestens eine Verbindung der chemischen Struktur **(II)** mit 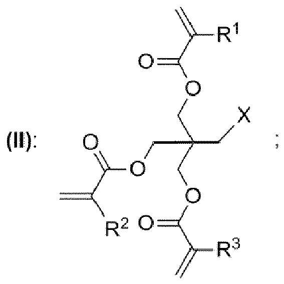 wobei X ausgewählt ist aus -H, -OH, unverzweigte oder verzweigte Alkylgruppe mit 1 bis 10 Kohlenstoffatomen, einem Rest der chemischen Strukturen **(III), (IV)** mit 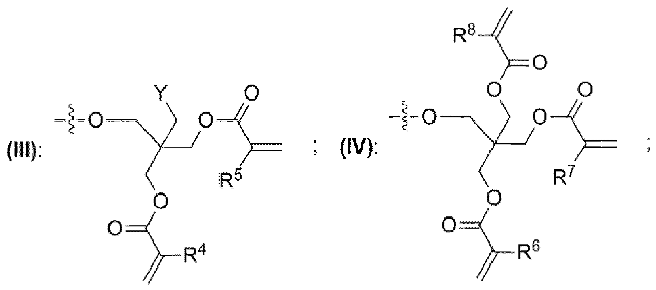 wobei Y ausgewählt ist aus -H, -OH, unverzweigte oder verzweigte Alkylgruppe mit 1 bis 10 Kohlenstoffatomen;
und wobei R¹, R², R³, R⁴, R⁵, R⁶, R⁷, R⁸ unabhängig voneinander jeweils Wasserstoff oder eine Methylgruppe ist.

2. Zusammensetzung **(A)** nach Anspruch 1, wobei die Verbindung **(I)** Triallylisocyanurat ist.

3. Zusammensetzung **(A)** nach Anspruch 1 oder 2, wobei X ausgewählt ist aus -OH, einem Rest der chemischen Strukturen **(III), (IV)** mit Y = OH, und wobei R¹, R², R³, R⁴, R⁵, R⁶, R⁷, R⁸ unabhängig voneinander jeweils Wasserstoff oder eine Methylgruppe ist.

4. Zusammensetzung **(A)** nach Anspruch 3, wobei X ein Rest ausgewählt aus den chemischen Strukturen **(III), (IV)** mit Y = OH ist, und wobei R¹, R², R³, R⁴, R⁵, R⁶, R⁷, R⁸ unabhängig voneinander jeweils Wasserstoff oder eine Methylgruppe ist.

5. Zusammensetzung **(A)** nach Anspruch 4, wobei X ein Rest der chemischen Struktur **(III)** mit Y = OH ist, und wobei R¹, R², R³, R⁴, R⁵ unabhängig voneinander jeweils Wasserstoff oder eine Methylgruppe ist.

6. Zusammensetzung **(A)** nach Anspruch 4, wobei X ein Rest der chemischen Struktur **(IV)** ist, und wobei R¹, R², R³, R⁶, R⁷, R⁸ unabhängig voneinander jeweils Wasserstoff oder eine Methylgruppe ist.

7. Zusammensetzung **(A)** nach einem der Ansprüche 1 bis 6, worin der Anteil an allen Verbindungen der chemischen Struktur **(II)** bezogen auf alle Verbindungen der chemischen Struktur **(I)** im Bereich 0.9 Mol.-% bis 21.0 Mol.-% liegt.

8. Zusammensetzung **(B)** umfassend mindestens ein Polyolefincopolymer und eine Zusammensetzung **(A)** nach einem der Ansprüche 1 bis 7.

9. Zusammensetzung **(B)** nach Anspruch 8, wobei das Polyolefincopolymer ein Ethylen-Vinylacetat-Copolymer ist.

10. Zusammensetzung **(B)** nach Anspruch 9, wobei das Ethylen-Vinylacetat-Copolymer einen Vinylacetatgehalt von 15 bis 50 Gew.-%, bezogen auf das Gesamtgewicht des Ethylen-Vinylacetat-Copolymers, bestimmt nach ASTM D 5594:1998, aufweist.

11. Zusammensetzung **(B)** nach einem der Ansprüche 8 bis 10, worin der Anteil an Zusammensetzung **(A)** bei 0.05 bis 10 Gew.-%, bezogen auf die Masse aller von der Zusammensetzung **(B)** umfassten Polyolefincopolymere, liegt.

12. Zusammensetzung **(B)** nach einem der Ansprüche 8 bis 11, welche zusätzlich mindestens einen Initiator ausgewählt aus der Gruppe bestehend aus peroxidischen Verbindungen, Azoverbindungen, Photoinitiatoren umfasst.

13. Zusammensetzung **(B)** nach Anspruch 12, wobei der Initiator eine peroxidische Verbindung ist.

14. Zusammensetzung **(B)** nach einem der Ansprüche 8 bis 13, welche zusätzlich mindestens eine weitere Verbindung ausgewählt aus der Gruppe bestehend aus Vernetzern, Silankupplungsmitteln, Antioxidantien, Alterungsschutzmitteln, Metalloxiden, Metallhydroxiden, Weißpigmenten umfasst.

15. Zusammensetzung **(B)** nach Anspruch 14, wobei die weitere Verbindung ein Silankupplungsmittel ist.

16. Verwendung einer Zusammensetzung **(B)** nach einem der Ansprüche 8 bis 15 zur Herstellung einer Folie zur Verkapselung einer elektronischen Vorrichtung.
